# EUROPEAN PATENT SPECIFICATION

(11) **EP 2 693 223 B1**
(45) Date of publication and mention of the grant of the patent: **28.07.2021**
(21) Application number: 12005658.5
(22) Date of filing: 03.08.2012
(51) Int. Cl.: G01R 15/04, G01R 1/18, G01R 15/14

(54) **Voltage measurement device with an insulating body**
Spannungsmessvorrichtung mit einem Isolierkörper
Dispositif de mesure de tension avec un corps isolant

(43) Date of publication of application: 05.02.2014
(73) Proprietor: ABB Schweiz AG, 5400 Baden (CH)
(72) Inventor: Javora, Radek, 624 00 Brno (CZ); Podzemny, Jaromir, 621 00 Brno (CZ); Raschka, David, 664 91 Ivancice (CZ); Pavlas, Marek, 68354 Otnice (CZ); Velesik, Petr, 602 00 Brno (CZ)
(74) Representative: Maiwald Patent- und Rechtsanwaltsgesellschaft mbH

(56) References cited:
- EP-A2- 0 510 427
- CN-Y- 2 689 243
- None

## Description

Voltage measurement device with an insulating body, for the use in medium or high voltage equipment or switchgears, with an impedance divider consisting of at least one high voltage impedance and at least one low voltage impedance in series, and with shielding electrodes, according to the preamble of claim 1.

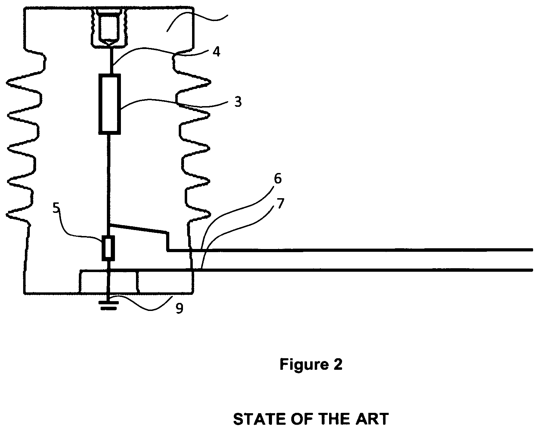

Voltage measurement devices for medium and high voltage applications use resistive and/or capacitive dividers for voltage measurement and/or for protection purposes of for example switchgear arrangements. Such devices, which operates at medium or at high voltage levels, may be exposed to a strong electric field which, being placed at very close vicinity, may influence measured quantities mainly in case of low-power outputs or introduce high dielectric stress on insulating material or on surface of such an equipment. Further influences could be observed, in case of outdoor installations, during humid conditions, which may change electric field distribution thus causing error to measured voltage level or causing corona on the surface of devices or increased partial discharge level within devices. A version of a voltage divider used in the state of the art is shown in Fig. 2 Voltage divider consists of insulating body, which is housing high voltage impedance being connected to high voltage at one end and to low voltage impedance at the other end. Low-voltage impedance needs to be connected to the ground. Output of such impedance divider is done by means of two wires and/or a cable. Examples of known voltage dividers are disclosed in EP 0 510 427 A2 and CN 2 689 243 Y, wherein the shielding elements surround the full length of the resistor only partly, so that a shielding gap occurs along the physical length of the resisitor.

Disadvantage of the well known arrangement is, that higher susceptibility to parasitic capacitances and possibility to change accuracy of measured voltage providing inaccurate values for protection and/or measurement purposes occurs.

So it is the object of the invention, that voltage sensor design needs to be optimized for a given application, preventing the risk of malfunction in case the same device is used in other application or at severe environmental or operating conditions.

This is fulfilled by the invention by that at least one high voltage shielding electrode and/or at least one low voltage shielding electrode whose dimensions are applied to the physical length of the impedances, and that the shielding electrodes surround the high and/or low voltage impedances providing required voltage division ratio, and which are located either inside or outside of the insulating body in order to distribute the electric field in the best way to reduce electric field stress either inside or outside of the said device, and that the output of the impedance divider is connected to a shielded cable, which is also part of this device.

So it is important, that the solution to the above mentioned problem is a combination of features, where functional cooperation leads to a better accuracy of voltage measurement in medium and/or high voltage use.

In an advantageous embodiment the shielding electrodes are in ring or bell shapes, having roundings at the edges with radius of at least 0.5mm.

A further advantageous embodiment is given by that the internal shielding electrodes are longer than the physical length of impedances they protect.

In a further advantageous embodiment is said, that the internal shielding electrodes are located minimum 1mm from the surface of the insulating body. This is case of the location of the shielding electrodes within the insulating body.

Important and advantageous is the embodiment in which the distance of the shielding electrodes from the impedance divider is bigger than dielectric withstand of used insulating material for a given voltage level under which the impedances are operating.

A futher important embodiment is, that the distance between the two shielding electrodes is bigger than dielectric withstand of used insulating material for a given voltage level which occurs in the area between said electrodes.

In a further embodiment are given options which are advantageous each itself, in that the impedance divider is either resistive divider, or capacitive divider, or combination of both.

As an advantageous embodiment is given, that the shielded cable is a twisted pair and/or double shielded cable, in order to achieve the best electric and magnetic field immunity for output cable from the device.

As an advantageous alternative is applied, that the shielded cable is a coaxial cable with sufficient performance in order to reduce costs of the whole device.

In a further advantageous embodiment the insulating body accommodating capacitive electrodes is created by conventional insulator used by voltage detecting systems and only external shielding electrodes are used in this case.

A further advantageous embodiment is, that the insulating body has a shape and/or functionality of post insulator, or bushing or cable plug or it can be designed as a stand-alone voltage measurement module to be integrated into other devices.

Embodiments of the invention are shown as follows.
Figure 1: New Sensor Design
Figure 2: Standard voltage divider

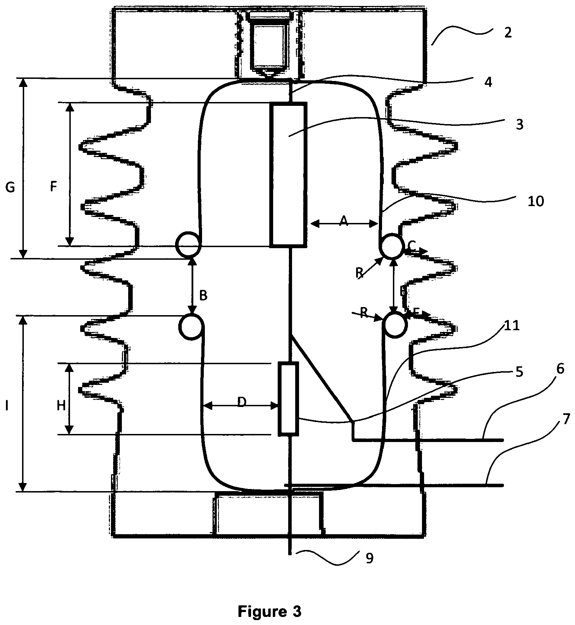

Figure 3: Design of the electrodes
Figure 4: Voltage sensor concept with external electrodes

This invention proposes the use of certain shape of shielding electrodes which are suitable mainly for resistive dividers, but given rules and principles could be adapted to capacitive dividers as well as to capacitive-resistive dividers.

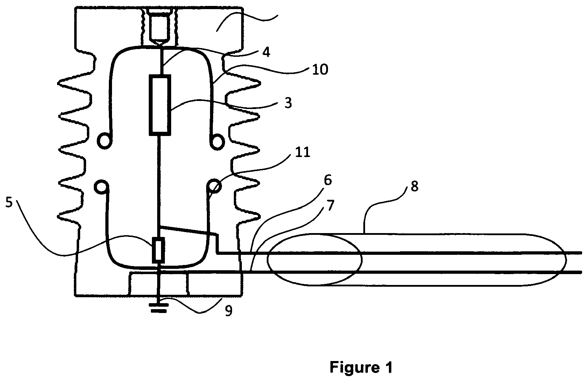

Fig. 1 describes general impedance divider. Insulating body 2 accomodates impedance 3 which is connected at one end to high voltage by connection 4 and at the other end to low-voltage impedance 5. Both high-voltage impedance 3 and low-voltage impedance 5 form a voltage divider with given division ratio. Voltage divider is grounded through connection 9 and output wires 6 and 7 go through the cable 8 which is shielded in order to minimize effects of external field on low-voltage signal going through the wires 6 and 7.

In order to reduce capacitive pick-up from external voltage sources or fields, shielding electrodes can be used. Fig. 1 shows upper-shielding electrode 10 which protect high-voltage impedance 3 from external influences and lower-shielding electrode 11 which protects low-voltage impedance 5 from external influences.

Apart from external influences, shielding electrodes 10 and 11 improve electric field distribution on surface of the insulating body 2 or within that insulating body, thus enables higher dielectric withstand of the device.

The use of shielding electrodes minimizes sensitivity of the voltage divider towards external connections to high-voltage or to other surrounding devices connected to high potential.

Best results to minimize external influences towards measuring impedances, to provide improved electric field distribution within the insulating body and on its surface as well and to minimize effect of connected equipment, its position and shape, could be achieved by following certain positioning and dimensioning rules for shielding electrodes:
- Length G of the upper shielding electrode 10 must be bigger than the length F of the high-voltage impedance 3 in order to sufficiently shield the whole high-voltage impedance from external influences.
- Length I of the lower shielding electrode 11 must be bigger than the size H of the low-voltage impedance 5 in order to sufficiently shield the whole low-voltage impedance from external influences
- Distance A of the upper shielding electrode 10 from the high-voltage impedance 3 must be bigger than dielectric withstand of used insulating material for a given voltage level under which the device is operating or being tested according to relevant standards.
- Distance D of the lower shielding electrode 11 from the low-voltage impedance 5 must be bigger than dielectric withstand of used insulating material for a given voltage level at low-voltage impedance side.
- Distance B of the upper shielding electrode 10 from lower shielding electrode 11 must be bigger than dielectric withstand of used insulating material for a given voltage level under which the device is operating or being tested according to relevant standards. This distance may also influence phase displacement of the measured signal and thus it can improve phase error of the whole device.
- In order to provide the best electric field distribution between high-voltage electrode 10 and low-voltage electrode 11, the radius R of ends of said electrodes needs to be bigger than 0.5mm.
- Distances E and C from shielding electrodes 10 and 11 towards insulating body 2 must be bigger than dielectric withstand of used insulating material for a given voltage level the electrodes are connected to. They need to be preferably higher than 1mm.
- The bigger are dimensions B, R, E and C the better electric field distribution on the surface of the insulating body.
- The bigger are dimensions A and D the better electric field distribution on the impedance divider elements, thus reducing risk of partial discharges and dielectric breakdown.

This option provides the best results, independently of the application where/how this device is used. In case of simple arrangements in applications or less complex structures with reduced possibility for external influences, simplified structure of shielding electrodes could be used.

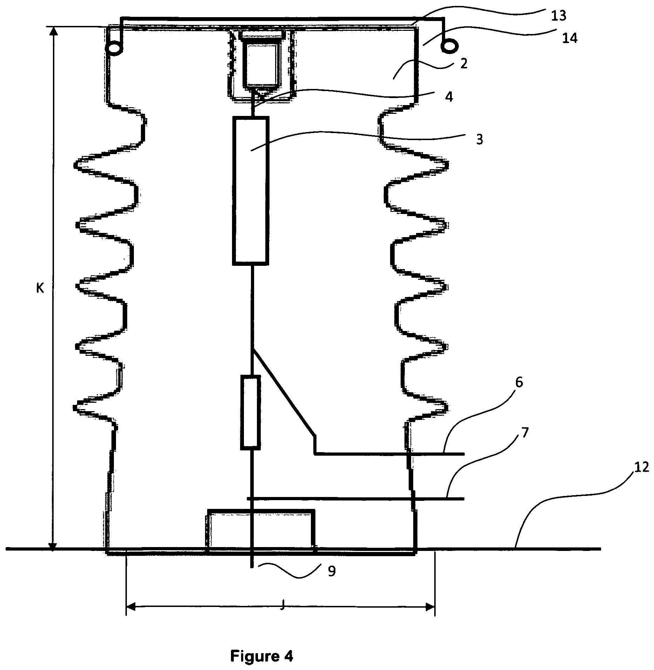

Referring to Fig. 4, lower shielding electrode 11 could be avoided in cases, when the device 1 is mounted on electrically conductive material, e.g. sheet of metal, which has the size bigger than diameter J of the insulating body 2. If the height K of the insulating body 2 is smaller than than two times the distance J and there is no other voltage source in distance from insulating body 2 less than in distance K, the lower shielding electrode 11 could be easily avoided and replaced by baseplate 12 to which the device is mounted. This arrangement could achieve a good dielectric field distribution within the high voltage part and the ground, to which the baseplate 12 is usually connected.

Further simplification could be done in upper shielding electrode 10. Internal electrode 10 could be avoided in case the connection towards high voltage is done by busbar, whose width is bigger than outer diameter L of insulating body 2. In this case, connected busbar is able to distribute properly the electric field and it may, in same extend, also provide shielding towards external influences. In case the connection towards high voltage is not realized by busbar, but in other way, e.g. by some kind of flexible connection, the upper shielding electrode might be needed. In order to avoid using internal upper electrode 10, one can use external electrode 13 located at the top of the insulating body. To minimize dielectric stress coming from sharp edges of this electrode, it is advantageous to provide rounding 14 of the edges of electrode 13. Rounding 14 should have radius at least 0.5mm.

## Claims

1. Voltage measurement device with an insulating body (2), for the use in medium or high voltage equipment or switchgears, the device comprising:
- at least one high voltage impedance (3);
- at least one low voltage impedance (5);
- a first shielding electrode (10);
- a second shielding electrode (11);
wherein the at least one high voltage impedance and the at least one low voltage impedance are located within the insulating body along an axis of the device;
wherein a first end of the at least one high voltage impedance is connected via a connection (4) to a high voltage;
wherein a first end of the at least one low voltage impedance is connected via a connection (9) to ground;
wherein a second end of the at least one high voltage impedance opposite to the first end is connected via a connection to a second end of the at least one low voltage impedance opposite to the first end;
wherein the at least one high voltage impedance and the at least one low voltage impedance form a voltage divider with a given division ratio;
**characterized in that**
the first shielding electrode and the second shielding electrode are located within the insulating body;
wherein the first shielding electrode has a ring or bell shape with an opening at a first end with a radius at the edges of the opening at least 0.5mm, and wherein the first shielding electrode surrounds the at least one high voltage impedance;
wherein the second shielding electrode has a ring or bell shape with an opening at a first end with a radius at the edges of the opening at least 0.5mm, and wherein the second shielding electrode surrounds the at least one low voltage impedance;
wherein the first end of the first shielding electrode faces the first end of the second shielding electrode;
wherein in a direction perpendicular to the axis an outer surface of the first shielding electrode is spaced from an inner surface of the insulating body by a distance of at least 1mm;
wherein in a direction perpendicular to the axis an outer surface of the second shielding electrode is spaced from the inner surface of the insulating body by a distance of at least 1mm;
wherein the first shielding electrode is connected at a second end opposite to the first end to the connection to the high voltage, and wherein a length measured in the direction of the axis from the second end of the first shielding electrode to the first end of the first shielding electrode is greater than a length measured in the direction of the axis from the second end of the first shielding electrode to the second end of the at least one high voltage impedance; and
wherein the second shielding electrode is connected at a second end opposite to the first end to the connection to ground, and wherein a length measured in the direction of the axis from the second end of the second shielding electrode to the first end of the second shielding electrode is greater than a length measured in the direction of the axis from the second end of the second shielding electrode to the second end of the at least one low voltage impedance.

## Patentansprüche

1. Spannungsmessvorrichtung mit einem Isolierkörper (2) zur Verwendung in Mittel- oder Hochspannungseinrichtungen oder -schaltgeräten, wobei die Vorrichtung umfasst:
- mindestens eine Hochspannungsimpedanz (3);
- mindestens eine Niederspannungsimpedanz (5);
- eine erste Abschirmelektrode (10);
- eine zweite Abschirmelektrode (11);
wobei die mindestens eine Hochspannungsimpedanz und die mindestens eine Niederspannungsimpedanz sich innerhalb des Isolierkörpers entlang einer Achse der Vorrichtung befinden;
wobei ein erstes Ende der mindestens einen Hochspannungsimpedanz über eine Verbindung (4) mit einer Hochspannung verbunden ist;
wobei ein erstes Ende der mindestens einen Niederspannungsimpedanz über eine Verbindung (9) mit Masse verbunden ist;
wobei ein zweites Ende der mindestens einen Hochspannungsimpedanz gegenüber dem ersten Ende über eine Verbindung mit einem zweiten Ende der mindestens einen Niederspannungsimpedanz gegenüber dem ersten Ende verbunden ist,
wobei die mindestens eine Hochspannungsimpedanz und die mindestens eine Niederspannungsimpedanz einen Spannungsteiler mit einem gegebenen Teilungsverhältnis bilden;
**dadurch gekennzeichnet, dass**
die erste Abschirmelektrode und die zweite Abschirmelektrode sich innerhalb des Isolierkörpers befinden;
wobei die erste Abschirmelektrode eine Ring- oder Glockenform mit einer Öffnung an einem ersten Ende aufweist, wobei ein Radius an den Rändern der Öffnung mindestens 0,5 mm beträgt, und wobei die erste Abschirmelektrode die mindestens eine Hochspannungsimpedanz umgibt;
wobei die zweite Abschirmelektrode eine Ring- oder Glockenform mit einer Öffnung an einem ersten Ende aufweist, wobei ein Radius an den Rändern der Öffnung mindestens 0,5 mm beträgt, und wobei die zweite Abschirmelektrode die mindestens eine Niederspannungsimpedanz umgibt;
wobei das erste Ende der Abschirmelektrode dem ersten Ende der zweiten Abschirmelektrode gegenüberliegt;
wobei in einer Richtung senkrecht zur Achse eine Außenfläche der ersten Abschirmelektrode von einer Innenfläche des Isolierkörpers um eine Distanz von mindestens 1 mm beabstandet ist;
wobei in einer Richtung senkrecht zur Achse eine Außenfläche der zweiten Abschirmelektrode von der Innenfläche des Isolierkörpers um eine Distanz von mindestens 1 mm beabstandet ist;
wobei die erste Abschirmelektrode an einem zweiten Ende gegenüber dem ersten Ende mit der Verbindung zur Hochspannung verbunden ist, und wobei eine in Richtung der Achse vom zweiten Ende der ersten Abschirmelektrode zum ersten Ende der ersten Abschirmelektrode gemessene Länge größer als eine in Richtung der Achse vom zweiten Ende der ersten Abschirmelektrode zum zweiten Ende der mindestens einen Hochspannungsimpedanz gemessene Länge ist,
wobei die zweite Abschirmelektrode an einem zweiten Ende gegenüber dem ersten Ende mit der Verbindung zur Masse verbunden ist, und wobei eine in Richtung der Achse vom zweiten Ende der zweiten Abschirmelektrode zum ersten Ende der zweiten Abschirmelektrode gemessene Länge größer als eine in Richtung der Achse vom zweiten Ende der zweiten Abschirmelektrode zum zweiten Ende der mindestens einen Niederspannungsimpedanz gemessene Länge ist.

## Revendications

1. Dispositif de mesure de tension à corps isolant (2), destiné à être utilisé dans un équipement, ou un appareillage de commutation, de moyenne ou haute tension, le dispositif comprenant :
- au moins une impédance haute tension (3) ;
- au moins une impédance basse tension (5) ;
- une première électrode de blindage (10) ;
- une seconde électrode de blindage (11) ;
dans lequel l'au moins une impédance haute tension et l'au moins une impédance basse tension sont disposées à l'intérieur du corps isolant le long d'un axe du dispositif ;
dans lequel une première extrémité de l'au moins une impédance haute tension est connectée par une connexion (4) à une haute tension ;
dans lequel une première extrémité de l'au moins une impédance basse tension est connectée par une connexion (9) à la masse ;
dans lequel une seconde extrémité de l'au moins une impédance haute tension opposée à la première extrémité est connectée par une connexion à une seconde extrémité de l'au moins une impédance basse tension opposée à la première extrémité ;
dans lequel l'au moins une impédance haute tension et l'au moins une impédance basse tension forment un diviseur de tension à rapport de division donné ;
**caractérisé en ce que**
la première électrode de blindage et la seconde électrode de blindage sont disposées à l'intérieur du corps isolant ;
dans lequel la première électrode de blindage a la forme d'une bague ou cloche présentant à une première extrémité une ouverture d'un rayon au bord de l'ouverture d'au moins 0,5 mm, et la première électrode de blindage entourant l'au moins une impédance haute tension ;
dans lequel la seconde électrode de blindage a la forme d'une bague ou cloche présentant à une première extrémité une ouverture d'un rayon au bord de l'ouverture d'au moins 0,5 mm, et la seconde électrode de blindage entourant l'au moins une impédance basse tension ;
dans lequel la première extrémité de la première électrode de blindage fait face à la première extrémité de la seconde électrode de blindage ;
dans lequel dans une direction perpendiculaire à l'axe une surface externe de la première électrode de blindage est espacée d'une surface interne du corps isolant par une distance d'au moins 1 mm ;
dans lequel dans une direction perpendiculaire à l'axe une surface externe de la seconde électrode de blindage est espacée de la surface interne du corps isolant par une distance d'au moins 1 mm ;
dans lequel la première électrode de blindage est connectée au niveau d'une seconde extrémité opposée à la première extrémité à la connexion à la haute tension, et dans lequel une longueur mesurée dans la direction de l'axe depuis la seconde extrémité de la première électrode de blindage jusqu'à la première extrémité de la première électrode de blindage est supérieure à une longueur mesurée dans la direction de l'axe depuis la seconde extrémité de la première électrode de blindage jusqu'à la seconde extrémité de l'au moins une impédance haute tension ; et
dans lequel la seconde électrode de blindage est connectée au niveau d'une seconde extrémité opposée à la première extrémité à la connexion à la masse, et dans lequel une longueur mesurée dans la direction de l'axe depuis la seconde extrémité de la seconde électrode de blindage jusqu'à la première extrémité de la seconde électrode de blindage est supérieure à une longueur mesurée dans la direction de l'axe depuis la seconde électrode de blindage jusqu'à la seconde extrémité de l'au moins une impédance basse tension.
